# EUROPÄISCHE PATENTSCHRIFT

(11) **EP 3 534 621 B1**
(45) Veröffentlichungstag und Bekanntmachung des Hinweises auf die Patenterteilung: **23.12.2020**
(21) Anmeldenummer: 19158634.6
(22) Anmeldetag: 21.02.2019
(51) Int. Cl.: H04R 3/04, H04R 29/00, H04R 17/00, H04R 1/00, H01L 41/04

(54) **VERFAHREN ZUM BETREIBEN EINES PIEZOELEKTRISCHEN LAUTSPRECHERS**
METHOD FOR OPERATING A PIEZOELECTRIC SPEAKER
PROCÉDÉ DE FONCTIONNEMENT D'UN HAUT-PARLEUR PIÉZOÉLECTRIQUE

(30) Priorität: 28.02.2018 DE 102018104561
(43) Veröffentlichungstag der Anmeldung: 04.09.2019
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); STRLE, Drago, 1000 Ljubljana (SI)
(74) Vertreter: Bergmeier, Ulrich

(56) Entgegenhaltungen:
- WO-A2-01/20948
- WO-A2-2009/066296
- SPANNER K ET AL: "PIEZO-TRANSLATOREN", ELEKTRONIK, W E K A FACHZEITSCHRIFTEN-VERLAG GMBH, DE, Bd. 31, Nr. 6, 26. März 1982 (1982-03-26), Seiten 91-94, XP000795512, ISSN: 0013-5658

## Beschreibung

Die vorliegende Erfindung betrifft ein Verfahren zum Betreiben eines piezoelektrischen Lautsprechers zum Erzeugen von Schallwellen im hörbaren Wellenlängenspektrum und/oder im Ultraschallbereich, bei dem ein Piezoaktor des piezoelektrischen Lautsprechers mit elektrischer Energie einer Energieeinheit zumindest teilweise geladen und wieder zumindest teilweise entladen wird, wodurch Schallwellen erzeugt werden. Außerdem wird beim Verfahren eine gegenwärtige elektrische Piezoaktorspannung des Piezoaktors ermittelt. Ferner betrifft die Erfindung eine Schaltung zum Betreiben eines piezoelektrischen Lautsprechers.

Aus der US 2010/0271147 A1 ist eine Schaltung für ein piezoelektrisches Element bekannt. Darin wird zum Laden elektrische Energie von einem Energiespeicher auf das piezoelektrische Element und zum Entladen vom piezoelektrischen Element auf den Energiespeicher geladen. Ferner wird eine Spannung am piezoelektrischen Element gemessen und mit einer momentanen Eingangsspannung verglichen. Nachteilig daran ist es, dass eine Qualität eines wiedergegebenen Schalls mit dem piezoelektrischen Element gemäß der US 2010/0271147 A1 unzureichend ist.

Weiterer relevanter Stand der Technik zur Ansteuerung piezoelektrischer Wandler findet sich in WO 01/20948 A2, sowie in Spanner, K., et al: "Piezo-Translatoren (in ELEKTRONIK, WEKA Fachzeitschriften-Verlag GmbH, Band 31, Nr.6, 26.03.1982, Seiten 91-94).

Aufgabe der vorliegenden Erfindung ist es somit, den Stand der Technik zu verbessern.

Die Aufgabe wird gelöst durch ein Verfahren zum Betreiben eines piezoelektrischen Lautsprechers und eine Schaltung mit den Merkmalen der unabhängigen Patentansprüche.

Vorgeschlagen wird ein Verfahren zum Betreiben eines piezoelektrischen Lautsprechers zum Erzeugen von Schallwellen im hörbaren Wellenlängenspektrum. Der piezoelektrische Lautsprecher kann beispielsweise in einem Smartphone, einem Kopfhörer, einem In-Ear-Kopfhörer oder ähnlichem angeordnet sein, um Musik, Töne oder Sprache zu erzeugen. Die Schallwellen im hörbaren Wellenlängenspektrum können beispielsweise Frequenzen von ungefähr 20 Hz bis 20 kHz aufweisen, so dass sie für das menschliche Gehör wahrnehmbar sind.

Zusätzlich oder alternativ können mit dem piezoelektrischen Lautsprecher auch Schallwellen im Ultraschallbereich erzeugt werden. Derartige Schallwellen weisen dabei Frequenzen oberhalb von etwa 20 kHz auf. Mit Hilfe des piezoelektrischen Lautsprechers kann somit Ultraschall erzeugt werden. Der piezoelektrische Lautsprecher kann dadurch in der Medizintechnik Anwendungen finden, beispielsweise für Sonographie. Daneben sind aber auch andere Anwendungen denkbar. Beispielsweise kann der mittels des piezoelektrischen Lautsprechers erzeugte Ultraschall auch für eine Abstandsmessung, insbesondere Echolot, für eine Ultraschallreinigung, für einen Bewegungsmelder, zum Ultraschallschweißen, für Ultraschalllevitation, für Ultraschallprüfgeräte für Materialprüfung, für Ultraschalllinearantriebe, für Ultraschalldurchflusssensoren oder zum Ultraschallschneiden verwendet werden.

Beim Verfahren wird ein Piezoaktor des piezoelektrischen Lautsprechers mit elektrischer Energie einer Energieeinheit zumindest teilweise geladen und wieder zumindest teilweise entladen, wodurch Schallwellen erzeugt werden. Die elektrische Energie kann dabei von der Energieeinheit bereitgestellt werden. Der Piezoaktor weist piezoelektrische Eigenschaften auf, das heißt, der Piezoaktor kann in Abhängigkeit seines Ladezustandes ausgelenkt werden. Je höher die Aufladung des Piezoaktors mit elektrischer Energie ist, desto höher ist auch die Auslenkung des Piezoaktors. Mit Hilfe der Auslenkung des Piezoaktors können die Schallwellen erzeugt werden, wenn die Auslenkung beispielsweise auf eine Membran übertragen wird. Dadurch kann die über der Membran angeordnete Luft in Schwingung versetzt werden, so dass die Schallwellen erzeugt werden. Ferner kann die Auslenkung des Piezoaktors dadurch verändert werden, dass dieser geladen und entladen wird. Wird der Piezoaktor weiter geladen, kann die Auslenkung vergrößert werden. Um die Auslenkung dagegen zu verringern, kann der Piezoaktor entladen werden. Der Piezoaktor kann somit durch abwechselndes Laden und Entladen in Schwingung versetzt werden, wobei die Schwingungen beispielsweise auf die Membran übertragen werden, so dass die Schallwellen erzeugt werden.

Beim Verfahren wird zum Laden des Piezoaktors die elektrische Energie von einer Energieeinheit auf den Piezoaktor geladen. Die Energieeinheit kann dabei ein Energiespeicher, wie beispielsweise eine Batterie oder ein Akkumulator, sein. Mit Hilfe der Energieeinheit kann der piezoelektrische Lautsprecher betrieben werden. Das Laden kann, wie oben beschrieben ist, dann durchgeführt werden, wenn der Piezoaktor weiter ausgelenkt werden soll.

Des Weiteren wird beim Verfahren zum Entladen des Piezoaktors die elektrische Energie vom Piezoaktor entladen. Das Entladen kann beispielsweise dann durchgeführt werden, wenn die Auslenkung des Piezoaktors verringert werden soll. Außerdem kann die elektrische Energie vom Piezoaktor in die Energieeinheit geladen werden, so dass diese wieder zur Verfügung steht. Der piezoelektrische Lautsprecher kann dadurch effektiver betrieben werden.

Durch das gesteuerte Auslenken des Piezoaktors können somit Schallwellen erzeugt werden. Wenn das Auslenken gemäß einem Audiosignal erfolgt, das beispielsweise Ton, Schall oder Musik umfassen kann, wird mit Hilfe des piezoelektrischen Lautsprechers ein entsprechendes Geräusch, das ebenfalls Ton, Schall oder Musik umfasst, erzeugt. Das Audiosignal kann beispielsweise in Form einer Musikdatei vorliegen. Das Audiosignal kann aber auch beim Telefonieren von einem Gesprächspartner bereitgestellt werden.

Durch das Laden und das Entladen mit elektrischer Energie steigt bzw. sinkt auch eine elektrische Spannung am Piezoaktor. Mit steigender Spannung am Piezoaktor steigt die Auslenkung. Weiterhin verringert sich die Auslenkung, wenn die Spannung am Piezoaktor sinkt. Ferner weist der Piezoaktor eine Kapazität auf, da sich durch das Aufladen des Piezoaktor mit elektrischer Energie in Abhängigkeit der elektrischen Spannung ein elektrisches Feld aufbaut. Der Piezoaktor kann somit Eigenschaften eines Kondensators aufweisen. Außerdem können der Ladezustand bzw. die elektrische Spannung des Piezoaktors und die Auslenkung voneinander abhängen.

Des Weiteren wird beim Verfahren zumindest eine gegenwärtige elektrische Piezoaktorspannung des Piezoaktors ermittelt. Die gegenwärtige elektrische Piezoaktorspannung ist die elektrische Spannung die gegenwärtige bzw. momentan am Piezoaktor anliegt. Die gegenwärtige Piezoaktorspannung ist auch die Spannung, mit der der Piezoaktor gegenwärtige bzw. momentan aufgeladen ist. Dadurch kann auf die Auslenkung des Piezoaktors geschlossen werden, da die Auslenkung von der elektrischen Piezoaktorspannung abhängt.

Erfindungsgemäß wird vor dem Laden eine zukünftige Eingabespannung für den Piezoaktor mit der gegenwärtigen elektrischen Piezoaktorspannung verglichen. Zusätzlich oder alternativ kann vor dem Entladen die zukünftige Eingabespannung für den Piezoaktor mit der gegenwärtigen elektrischen Piezoaktorspannung verglichen werden. Daraus wird eine zukünftige Differenzspannung ermittelt. Die zukünftige Eingabespannung kann dabei die elektrische Spannung am Piezoaktor sein, die in einem zukünftigen, beispielsweise in einem nächsten, Zeitintervall am Piezoaktor anliegen soll. Die zukünftige Eingabespannung kann ein Sollwert für die Spannung am Piezoaktor sein. Die zukünftige Eingabespannung kann dabei auch eine zukünftige elektrische Piezoaktorspannung sein. Die zukünftige Differenzspannung kann eine Spannung sein, die einen Unterschied bzw. eine Differenz bei der zur Auslenkung korrespondierenden gegenwärtigen Piezoaktorspannung zur zukünftigen Eingabespannung ausgleicht.

Beträgt beispielsweise die gegenwärtige bzw. momentane Piezoaktorspannung 29,5 V, welche gemessen und/oder ermittelt werden kann, und die zukünftige Eingabespannung, welche beispielsweise in einem nächsten Zeitintervall am Piezoaktor anliegen soll, 30 V, kann daraus eine zukünftige Differenzspannung von 0,5 V ermittelt werden. In diesem Beispiel soll die Piezoaktorspannung von den gegenwärtigen 29,5 V auf die zukünftigen 30 V erhöht werden. Die am Piezoaktor anliegende Piezoaktorspannung muss somit um 0,5 V, insbesondere für das zukünftige und/oder nächste Zeitintervall, erhöht werden. Die Differenzspannung kann somit eine Ausgleichsspannung sein. Dadurch wird bereits zum gegenwärtigen Zeitpunkt die Differenzspannung für das nächste Zeitintervall ermittelt. Um einen Ton, Musik oder Sprache mit einer hohen Qualität erzeugen zu können, ist es vorteilhaft, wenn die Auslenkung des Piezoaktors mit einer möglichst hohen Präzision erfolgt. Durch das Vorausberechnen der zukünftigen Differenzspannung kann die Auslenkung mit einer hohen Präzision gesteuert werden. Dadurch wird eine Qualität der erzeugten Schallwellen, die einen Ton, eine Musik oder eine Sprache umfassen können, erhöht.

Die zukünftige Differenzspannung kann positiv sein, wenn der Piezoaktor geladen werden soll. Alternativ kann die zukünftige Differenzspannung negativ sein, wenn der Piezoaktor entladen werden soll.

Das nächste bzw. zukünftige Zeitintervall kann beispielsweise dem nächsten Laden oder Entladen des Piezoaktors entsprechen.

In einer vorteilhaften Weiterbildung der Erfindung wird aus einem zur Ausgabe am piezoelektrischen Lautsprecher vorgesehenen Audiosignal die zukünftige Eingabespannung des Piezoaktors ermittelt. Das Audiosignal kann dabei Töne, Musik oder Sprache umfassen, die mittels des piezoelektrischen Lautsprechers ausgegeben werden. Das Audiosignal kann aber auch die für die Ultraschallanwendung benötigten Signale umfassen. Das Audiosignal variiert dabei über die Zeit. Das Audiosignal umfasst im einfachsten Fall eine einzige Frequenz, wenn ein Ton mit der entsprechenden Frequenz am piezoelektrischen Lautsprecher ausgegeben werden soll. Das Audiosignal umfasst im Fall des einzigen Tons eine einzige periodische Schwingung, die mit einer Sinusschwingung beschrieben werden kann. Soll am piezoelektrischen Lautsprecher Sprache oder Musik ausgegeben werden, umfasst das Audiosignal eine Vielzahl an Frequenzen oder Schwingungen. Das Audiosignal ist dann ein kompliziertes zeitliches Signal. In beiden Fällen wird jedoch der Piezoaktor entsprechend dem Audiosignal ausgelenkt, um ein zum Audiosignal passenden Ton, eine passende Musik oder eine passende Sprache zu erzeugen. Der Piezoaktor wird somit entsprechend dem Audiosignal ausgelenkt. Die Tonqualität hängt somit davon ab, wie genau die Auslenkung des Piezoaktors in Abhängigkeit des Audiosignals erfolgt.

Vorteilhaft ist es, wenn beim Laden die elektrische Energie von der Energieeinheit auf eine Umladeeinheit und/oder von der Umladeeinheit in den Piezoaktor geladen wird. Zusätzlich oder alternativ kann beim Entladen des Piezoaktors die elektrische Energie vom Piezoaktor auf die Umladeeinheit und/oder von der Umladeeinheit in die Energieeinheit geladen werden. Die Umladeeinheit kann beispielsweise eine Spule mit einer Induktivität sein, so dass die elektrische Energie in Form eines elektrischen Stroms in der Umladeeinheit gespeichert wird. Dadurch kann beispielsweise ein elektrischer Schwingkreis ausgebildet werden. Der elektrische Schwingkreis kann zwischen der Umladeeinheit und dem Piezoaktor und/oder der Energieeinheit ausgebildet sein. Die elektrische Energie kann dann auf einfache Weise zwischen der Energieeinheit, der Umladeeinheit und dem Piezoaktor umgeladen werden.

Von Vorteil ist es auch, wenn zumindest aus der zukünftigen Differenzspannung eine zukünftige elektrische Differenzenergie ermittelt wird. Zusätzlich oder alternativ ist es von Vorteil, wenn zumindest aus der gemessenen Piezoaktorspannung die zukünftige elektrische Differenzenergie ermittelt wird. Beim Piezoaktor kann die Schwierigkeit auftreten, dass der Zusammenhang zwischen der zukünftigen Differenzspannung und der daraus resultierenden Auslenkung nicht linear ist. Im Allgemeinen ist der Zusammenhang nichtlinear. Dies kann darin begründet sein, dass sich bei der Auslenkung des Piezoaktors dessen Geometrie ändert und sich infolgedessen die Kapazität des Piezoaktors ändert. Die zusätzliche Auslenkung beim Laden oder Entladen bei einer gewissen Differenzspannung kann bei geringen Auslenkungen anders sein als bei hohen Auslenkungen. Insbesondere die von der Auslenkung abhängige Kapazität kann mit Hilfe der Ermittlung der zukünftigen elektrischen Differenzenergie berücksichtigt werden. Beispielsweise kann bei einer bereits vorhandenen hohen Auslenkung mehr Differenzenergie nötig sein als bei einer geringeren Auslenkung, um den Piezoaktor um den gleichen Betrag auszulenken. Ferner kann die zukünftige Differenzenergie auch von der gegenwärtigen bzw. momentanen Piezoaktorspannung abhängen. Des Weiteren kann die Differenzspannung noch von weiteren Faktoren, wie beispielsweise Widerständen in einer Schaltung der Energieeinheit, der Umladeeinheit und/oder des Piezoaktors, abhängen.

Die zukünftige elektrische Differenzenergie kann dabei positiv sein, wenn der Piezoaktor geladen werden soll. Alternativ kann die zukünftige elektrische Differenzenergie auch negativ sein, wenn der Piezoaktor entladen werden soll.

Vorteilhafterweise kann die zukünftige Differenzenergie beim Laden von der Energieeinheit in die Umladeeinheit geladen werden. Zusätzlich oder alternativ kann die zukünftige Differenzenergie von der Umladeeinheit in den Piezoaktor geladen werden.

Beim Entladen kann die zukünftige Differenzenergie vom Piezoaktor in die Umladeeinheit geladen werden. Zusätzlich oder alternativ kann die zukünftige Differenzenergie von der Umladeeinheit in die Energieeinheit geladen werden.

Ist die Umladeeinheit als Induktivität ausgebildet, kann die zukünftige Differenzenergie in Form eines elektrischen Stroms in der Umladeeinheit gespeichert werden. Der elektrische Strom fließt dabei durch die Umladeeinheit.

Vorteilhaft ist es, wenn in Abhängigkeit der zukünftigen Eingabespannung eine zukünftige Ladezeit ermittelt wird. Zusätzlich oder alternativ kann auch in Abhängigkeit der zukünftigen Differenzspannung die zukünftige Ladezeit ermittelt werden. Zusätzlich oder alternativ kann auch in Abhängigkeit der zukünftigen Differenzspannung die zukünftige Ladezeit ermittelt werden. Zusätzlich oder alternativ kann auch in Abhängigkeit der gemessenen Piezospannung die zukünftige Ladezeit ermittelt werden. Während der zukünftigen Ladezeit wird dabei die elektrische Energie, insbesondere die zukünftige Differenzenergie, von der Energieeinheit auf die Umladeeinheit geladen.

Vorteilhaft ist es auch, wenn in Abhängigkeit der zukünftigen Eingabespannung eine zukünftige Entladezeit ermittelt wird. Zusätzlich oder alternativ kann auch in Abhängigkeit der zukünftigen Differenzenergie die zukünftige Entladezeit ermittelt werden. Zusätzlich oder alternativ kann auch in Abhängigkeit der zukünftigen Differenzspannung die zukünftige Entladezeit ermittelt werden. Zusätzlich oder alternativ kann auch in Abhängigkeit der gemessenen Piezospannung die zukünftige Entladezeit ermittelt werden. Während der zukünftigen Entladezeit wird die elektrische Energie, insbesondere die zukünftige Differenzenergie, vom Piezoaktor in die Umladeeinheit geladen.

Dadurch kann ermittelt werden, mit welcher Dauer der Piezoaktor geladen oder entladen wird, um den Piezoaktor weiter oder weniger auszulenken, um gemäß dem Audiosignal Schallwellen mit einer hohen Qualität zu erzeugen. Mittels der Lade- und/oder Entladezeit kann auch die Schaltung gesteuert werden. Mit Hilfe der Lade- und/oder Entladezeit können beispielsweise Schalter der Schaltung entsprechend lang geöffnet und/oder geschlossen sein. Der Lade- und/oder Entladezeit kann dabei entsprechende Zeiten für Schalterzustände bzw. Schalterstellungen der Schaltung sein.

Von Vorteil ist es auch, wenn die Ladezeit in einer Speichereinheit gespeichert ist. Zusätzlich oder alternativ kann auch die Entladezeit in der Speichereinheit gespeichert sein. Der piezoelektrische Lautsprecher kann dabei die Speichereinheit umfassen. Ferner kann die gespeicherte Ladezeit und/oder die Entladezeit in Abhängigkeit der zukünftigen Eingabespannung, der gegenwärtigen Piezoaktorspannung, der zukünftigen Differenzspannung und/oder der zukünftigen Differenzenergie ermittelt und/oder ausgewählt werden. Dadurch kann für einen späteren Zeitpunkt die Ermittlung der verschiedenen genannten Werte verkürzt werden. In der Speichereinheit können die Ladezeit und/oder die Entladezeit als Liste abgespeichert werden. Wenn zu einem späteren Zeitpunkt die gegenwärtige Piezoaktorspannung gemessen wird, eine bestimmte zukünftige Eingabespannung, eine zukünftige Differenzenergie und/oder eine zukünftige Differenzspannung vorliegt, kann in der Liste nachgeschaut werden, ob dazu bereits die Ladezeit und/oder die Entladezeit vorhanden ist. Sind die Werte vorhanden, kann auf diese zurückgegriffen werden, ohne dass diese neu ermittelt werden müssen. Dadurch kann die Zeit für die Ermittlung der Werte eingespart werden.

Vorteilhaft ist es, wenn das Laden und/oder das Entladen des Piezoaktors mit Hilfe eines Pulsweitenmodulationsverfahrens durchgeführt wird. Eine Pulsweite und/oder eine Impulsdauer des Pulsweitenmodulationsverfahrens kann beispielsweise in Abhängigkeit der Ladezeit, der Entladezeit, der Differenzspannung und/oder der Differenzenergie ermittelt werden. Mit Hilfe des Pulsweitenmodulationsverfahrens können dann entsprechende Schalter einer Schaltung zum Laden und/oder Entladen des Piezoaktors gesteuert werden. Mit Hilfe des Pulsweitenmodulationsverfahrens können die Schalter der Schaltung entsprechend der Lade- und/oder Entladezeit geschlossen und/oder geöffnet werden.

Von Vorteil ist es, wenn das Laden, das Entladen und/oder das Ermitteln der Differenzspannung, der Differenzenergie, der Ladezeit, der Entladezeit und/oder das Ermitteln, insbesondere das Messen, der Piezoaktorspannung schrittweise und/oder periodisch mit einer Arbeitsfrequenz durchgeführt wird. Dadurch kann schrittweise und/oder periodisch der Piezoaktor geladen oder entladen werden. Zusätzlich oder alternativ können die genannten Werte schrittweise und/oder periodisch berechnet werden. Da beispielsweise die Piezoaktorspannung periodisch gemessen und beispielsweise die Differenzspannung periodisch ermittelt wird, kann periodisch auf die Piezoaktorspannung, was die Eingabespannung sein kann, geregelt werden. Dabei kann die Arbeitsfrequenz beispielsweise im Bereich von 1 MHz liegen. Die Arbeitsfrequenz kann somit die Taktfrequenz sein, mit der das Verfahren zum Betreiben des piezoelektrischen Lautsprechers durchgeführt und/oder eine Schaltung des piezoelektrischen Lautsprechers betrieben wird. Zusätzlich oder alternativ kann die Arbeitsfrequenz auch in einem Bereich liegen, die höher ist als eine Bandbreite des Audiosignals. Für Audiosignale kann beispielsweise eine Bandbreite von bis zu 20 kHz üblich sein. Das Audiosignal ändert sich somit beispielsweise mit einer Frequenz von 20 kHz. Das Audiosignal ändert sich somit mit einer Änderungsperiode von bis zu 50 µs. Die Arbeitsfrequenz kann dann beispielsweise 50-mal mal höher sein als die Bandbreite des Audiosignals. Dadurch wird beispielsweise ein Bereich von 1 MHz erreicht. Wenn Ultraschall erzeugt wird, liegt die Frequenz natürlich entsprechend höher.

Das Audiosignal ändert sich dabei höchstens mit der Bandbreite bzw. der Änderungsperiode. Ein Pegel des Audiosignals, das durch das Verfahren für den Piezoaktor aufbereitet wird, ändert sich in diesem Beispiel alle 1 µs bzw. mit der Arbeitsfrequenz von 1 MHz. Dadurch ändert sich gemäß diesem Beispiel auch die Auslenkung des Piezoaktors alle 1 µs bzw. mit der Arbeitsfrequenz von 1 MHz. Da der Piezoaktor der Änderungsrate der Auslenkung von 1 MHz, beispielsweise aufgrund der Trägheit, nicht folgen kann, ist die Auslenkung ein Durchschnitt aus mehreren Perioden der Arbeitsfrequenz.

Es ist weiterhin zwischen dem Audiosignal mit der Bandbreite bzw. der Änderungsperiode und dem Pegel des Audiosignals zu unterscheiden. Das Audiosignal kann beispielsweise in einer Musikdatei gespeichert sein und kann beispielsweise die Bandbreite von bis zu 20 kHz aufweisen, nämlich dem hörbaren Wellenlängenspektrum. Dagegen ändert sich der Pegel des Audiosignals mit der Arbeitsfrequenz, welcher durch das Verfahren für den Piezoaktor bearbeitet wird. Die Bandbreite kann somit beispielsweise eine vom Verfahren zum Betreiben des piezoelektrischen Lautsprechers unabhängige Frequenz sein. Die Änderungsrate oder auch die Abtastperiode des Pegels des Audiosignals kann vom Verfahren abhängen, nämlich der Arbeitsfrequenz, mit der das elektrische Signal für den Piezoaktor bereitgestellt wird.

Ist beispielsweise die Arbeitsfrequenz 50-mal höher als die Bandbreite des Audiosignals, kann pro Änderungsperiode des Audiosignals von beispielsweise 50 µs 50-mal die Piezoaktorspannung gemessen werden, die zukünftige Differenzspannung und/oder Differenzenergie ermittelt werden, die Lade- und/oder Entladezeit ermittelt und/oder der Piezoaktor geladen und/oder entladen werden. Die Piezoaktorspannung kann somit 50-mal pro Änderungsperiode des Audiosignals auf die Eingabespannung geregelt werden. Dadurch kann die Qualität der erzeugten Schallwellen erhöht werden. Schallwellen, die während der Regelung während einer Änderungsperiode des Audiosignals von 50 µs entstehen, weisen eine entsprechend hohe Frequenz auf. Beispielsweise liegt diese Frequenz im Bereich der Arbeitsfrequenz, so dass die Schallwellen eine Frequenz im Bereich von 1 MHz aufweisen. Schallwellen mit einer derartigen Frequenz liegen über dem für das menschliche Gehör hörbaren Wellenlängenspektrum, so dass die Regelung der Auslenkung des Piezoaktors mit der Arbeitsfrequenz keine bis wenig Auswirkungen auf die Qualität der Schallwellen, beispielsweise des Ton, der Musik oder der Sprachen, hat.

Vorteilhaft ist es, wenn eine Periode der Arbeitsfrequenz in eine erste Zeitspanne, in eine zweite Zeitspanne und eine dritte Zeitspanne unterteilt ist.

Dabei kann die zweite Zeitspanne zeitlich auf die erste Zeitspanne folgen. Zusätzlich oder alternativ kann auch die dritte Zeitspanne auf die zweite Zeitspanne folgen. In der ersten, der zweiten und/oder der dritten Zeitspanne kann das Laden, das Entladen und/oder das Ermitteln der Differenzspannung, der Differenzenergie, der Ladezeit, der Entladezeit und/oder das Messen der Piezoaktorspannung ausgeführt werden.

Von Vorteil ist es, wenn in der ersten Zeitspanne die elektrische Energie von der Energieeinheit auf die Umladeeinheit geladen wird. Die erste Zeitspanne ist beispielsweise die Zeitspanne, in der das Laden des Piezoaktors vorbereitet wird.

Das Laden der Umladeeinheit von der Energieeinheit kann dabei zu einem Zeitpunkt in der ersten Zeitspanne erfolgen, so dass zum Ende der ersten Zeitspanne in der Umladeeinheit die Differenzenergie gespeichert ist. Da es sich bei der Umladeeinheit um eine Induktivität handeln kann, kann die Differenzenergie in Form eines elektrischen Stroms durch die Induktivität gespeichert sein. Der Zeitpunkt, wann mit dem Laden der Umladeeinheit von der Energieeinheit begonnen wird, kann mittels der Ladezeit ermittelt werden. Dann befindet sich in der Umladeeinheit zum Ende der ersten Zeitspanne die, insbesondere vorher ermittelte, zukünftige Differenzenergie. Während der Ladezeit steigt dabei, wenn die Umladeeinheit die Form der Induktivität aufweist, der elektrische Strom, bis die Differenzenergie erreicht ist.

Vorteilhaft ist es außerdem, wenn das Laden und/oder das Entladen des Piezoaktors zu Beginn der zweiten Zeitspanne beginnt. Beim Laden kann beispielsweise die in der Umladeeinheit gespeicherte Energie auf den Piezoaktor geladen werden. Ist zum Ende der ersten Zeitspanne die Differenzenergie in die Umladeeinheit in Form des elektrischen Stroms geladen, ist es vorteilhaft, wenn im Anschluss, also zu Beginn der auf die erste Zeitspanne folgenden zweiten Zeitspanne, die Differenzenergie auf den Piezoaktor geladen wird. Dieses unterbrechungsfreie Umladen ist vorteilhaft, weil die Differenzenergie in Form des elektrischen Stroms vorliegt, und dieser nur in einem Stromkreis fließen kann. Während der zweiten Zeitspanne sinkt die in der Umladeeinheit gespeicherte elektrische Energie. Ist die Umladeeinheit als Induktivität ausgeführt, sinkt der elektrische Strom durch die Induktivität. Dagegen steigt während der zweiten Zeitspanne im Piezoaktor die elektrische Energie. Da der Piezoaktor Eigenschaften eines Kondensators aufweist, steigt mit der elektrischen Energie die elektrische Spannung des Piezoaktors, infolgedessen die Auslenkung des Piezoaktors steigt und Schall erzeugt wird. Dabei sind die Zeiten des Umladens der elektrischen Energie während der ersten Zeitspanne, beispielsweise anhand der Ladezeit, mittels der ermittelten Piezoaktorspannung und der Eingabespannung ermittelt, so dass nach dem Umladen der elektrischen Energie von der Umladeeinheit auf den Piezoaktor dieser die zum vorgesehenen Audiosignal passende Auslenkung aufweist. Dadurch kann ein Schall, der einen Ton, eine Musik oder Sprache umfasst, mit einer hohen Qualität erzeugt werden.

Beim Entladen kann die in dem Piezoaktor gespeicherte Energie während der zweiten Zeitspanne in die Umladeeinheit geladen werden. Dabei ist es vorteilhaft, wenn in der Umladeeinheit keine elektrische Energie gespeichert ist. Ist die Umladeeinheit eine Induktivität fließt kein elektrischer Strom durch die Induktivität. Beim Entladen wird die elektrische Energie vom Piezoaktor in die Umladeeinheit geladen. Dabei sinkt die elektrische Spannung des Piezoaktors und die elektrische Energie in der Umladeeinheit steigt. Ist die Umladeeinheit als Induktivität ausgeführt, steigt der elektrische Strom durch die Induktivität. Dies kann für die Dauer der Entladezeit erfolgen. Nach der Entladezeit hat sich die elektrische Energie des Piezoaktors um die Differenzenergie verringert, welche nun in der Umladeeinheit ist. Durch das Verringern der elektrischen Energie um die Differenzenergie hat sich die Auslenkung des Piezoaktors verringert. Schall entsprechend des Audiosignals kann dadurch erzeugt werden.

Vorteilhaft ist es, wenn in der dritten Zeitspanne die Piezoaktorspannung gemessen, die Piezoaktorspannung digitalisiert, die Differenzspannung, die Eingabespannung, die Differenzenergie ermittelt, der Piezoaktor geladen und/oder der Piezoaktor entladen wird. Die dritte Zeitspanne kann dazu verwendet werden, um Berechnungen der genannten Werte durchzuführen. Zusätzlich oder alternativ kann die dritte Zeitspanne dazu verwendet werden, den Piezoaktor zu Entladen, wenn beispielsweise die zweite Zeitspanne nicht ausreicht.

Vorgeschlagen wird ferner eine Schaltung zum Betreiben eines piezoelektrischen Lautsprechers zum Erzeugen von Schallwellen im hörbaren Wellenlängenspektrum. Das hörbare Wellenlängenspektrum umfasst dabei Schallfrequenzen im Bereich von ungefähr 20 Hz bis 20 kHz. Zusätzlich oder alternativ können mittels des piezoelektrischen Lautsprechers auch Schallwellen im Ultraschallbereich erzeugt werden. Die Schallwellen weisen dann Frequenzen oberhalb von 20 kHz auf. Mit Hilfe der Schaltung kann ein Piezoaktor des piezoelektrischen Lautsprechers geladen und/oder entladen werden, so dass Auslenkungen des Piezoaktors ausbildbar sind. Der Piezoaktor weist piezoelektrische Eigenschaften auf. Das heißt, mit Hilfe des Ladens und/oder Entladens können Auslenkungen des Piezoaktors ausgebildet werden. Diese Auslenkungen können beispielsweise auf eine Membran übertragen werden, um die Schallwellen zu erzeugen.

Mit Hilfe der Schaltung ist ferner elektrische Energie zwischen einer Energieeinheit und dem Piezoaktor umladbar.

Erfindungsgemäß ist die Schaltung ausgebildet, diese nach einem Verfahren gemäß einem oder mehreren Merkmal(en) der vorangegangenen und/oder nachfolgenden Beschreibung zu betreiben.

Weitere Vorteile der Erfindung sind in den nachfolgenden Ausführungsbeispielen beschrieben. Es zeigen:
- **Figur 1**: eine Schaltung mit einer Schalterstellung zum Laden eines Piezoaktors,
- **Figur 2**: eine Schaltung mit einer Schalterstellung zum Laden eines Piezoaktors,
- **Figur 3**: eine Schaltung mit einer Schalterstellung zum Entladen eines Piezoaktors,
- **Figur 4**: eine Schaltung mit einer Schalterstellung zum Entladen eines Piezoaktors,
- **Figur 5**: ein Blockdiagramm eines Verfahrens zum Betreiben eines piezoelektrischen Lautsprechers und
- **Figur 6**: ein Diagramm mit zeitlichen Schaltersignalen, einem zeitlichen Stromverlauf und einem zeitlichen Spannungsverlauf.

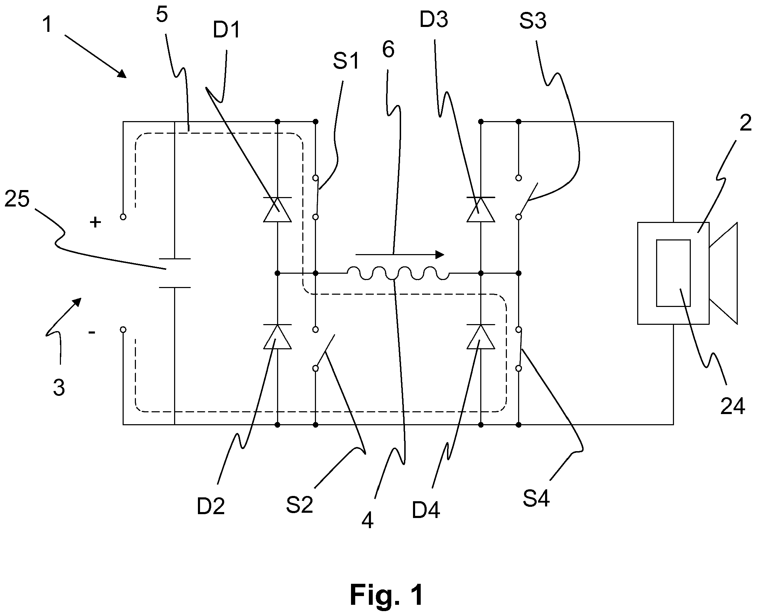

Figur 1 zeigt eine Schaltung 1 zum Betreiben eines piezoelektrischen Lautsprechers 2. In dem gezeigten Ausführungsbeispiel ist ein erster Schritt zum Laden eines hier nicht gezeigten Piezoaktors 24 des piezoelektrischen Lautsprechers 2 gezeigt. Der Piezoaktor 24 ist im piezoelektrischen Lautsprecher 2 angeordnet und hier schematisch gezeigt.

Die Schaltung 1 umfasst zumindest einen Schalter S1 - S4. Zusätzlich oder alternativ weist die Schaltung zumindest eine Diode D1 - D4 auf. Mit Hilfe des zumindest einen Schalters S1 - S4 und/oder der zumindest einen Diode D1 - D4 kann elektrische Energie zwischen einer Energieeinheit 3 und dem Piezoaktor 24 des piezoelektrischen Lautsprechers 2 umgeladen werden. Gemäß dem vorliegenden Ausführungsbeispiel weist die Schaltung 1 vier Schalter S1 - S4 und vier Dioden D1 - D4 auf. Die Energieeinheit 3 und/oder der piezoelektrische Lautsprecher 2 können dabei an die Schaltung 1 angeschlossen sein. Die Energieeinheit 3 kann beispielsweise eine Batterie oder ein Akkumulator sein.

Die Dioden D1 - D4 können dazu verwendet werden, um den Stromfluss zu ermöglichen, wenn die Schalter S1 - S4 noch nicht geschlossen sind.

Parallel zur Energieeinheit 3 kann gemäß dem vorliegenden Ausführungsbeispiel ein Kondensator 25 angeordnet sein, um eine Spannung der Energieeinheit 3 zu stabilisieren.

Der Piezoaktor 24 weist piezoelektrische Eigenschaften auf. Das heißt, wird der Piezoaktor 24 geladen oder entladen, kann eine Auslenkung des Piezoaktors 24 ausgebildet bzw. verändert werden. Infolge der Auslenkung können Schallwellen erzeugt werden, die einen Ton, eine Musik oder eine Sprache umfassen können. Um die Schallwellen zu erzeugen, kann die Auslenkung auf eine Membran des piezoelektrischen Lautsprechers 2 übertragen werden. Die über der Membran angeordnete Luft kann durch die Auslenkung in Schwingung versetzt werden. Wird der Piezoaktor 24 gemäß einem Audiosignal ausgelenkt, können Schallwellen erzeugt werden, die die im Audiosignal enthaltene Musik, Sprache oder Töne entsprechen. Mit Hilfe des piezoelektrischen Lautsprechers 2 bzw. des Piezoaktors 24 können zusätzlich oder alternativ auch Schallwellen im Ultraschallbereich erzeugt werden. Das Audiosignal umfasst dann Signale, die Ultraschall erzeugen.

Gemäß dem in Figur 1 gezeigten Ausführungsbeispiel ist ein Verfahren gezeigt, bei dem elektrische Energie von der Energieeinheit 3 zum Piezoaktor 24 geladen wird. In einem ersten Schritt wird dazu elektrische Energie von der Energieeinheit 3 auf eine Umladeeinheit 4 der Schaltung 1 übertragen. Die Umladeeinheit 4 ist des Weiteren in diesem Ausführungsbeispiel als Induktivität ausgebildet.

Gemäß dem vorliegenden Ausführungsbeispiel sind dazu der erste Schalter S1 und der vierte Schalter S4 geschlossen. Die Energieeinheit 3 kann ferner die in Figur 1 gezeigte Polung +/- aufweisen, wobei die Energieeinheit 3 eine Versorgungsspannung aufweist, die beispielsweise 3 V betragen kann. Durch die geschlossenen Schalter S1 und S4 kann ein elektrischer Strom 5 ausgebildet sein, der in Stromrichtung 6 durch die Umladeeinheit 4 fließt. Da die Umladeeinheit 4 hier als Induktivität ausgebildet ist, wird mit der Zeit der elektrische Strom 5 durch die Umladeeinheit 4 stärker. In Abhängigkeit des elektrischen Stroms 5 durch die Umladeeinheit 4 wird darin eine elektrische Energie gespeichert.

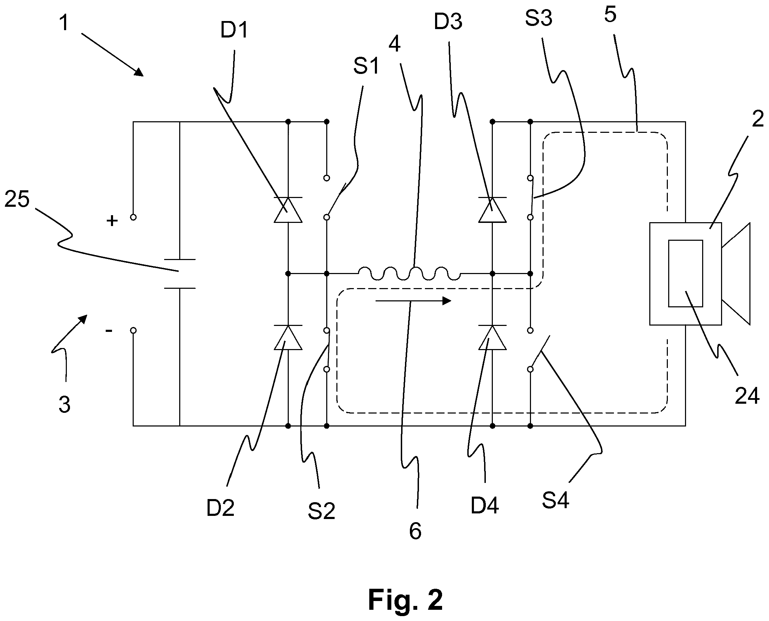

Figur 2 zeigt die Schaltung 1 mit einer weiteren Schalterstellung zum Laden des Piezoaktors 24. Gemäß dem vorliegenden Ausführungsbeispiel sind der erste Schalter S1 und der vierte Schalter S4 geöffnet. Ferner ist der zweite Schalter S2 und der dritte Schalter S3 geschlossen. Der Strom 5 fließt nun von der als Induktivität ausgeführten Umladeeinheit 4 zum Piezoaktor 24 des piezoelektrischen Lautsprechers 2. Der Strom 5 fließt dabei in Stromrichtung 6. Die elektrische Energie wird dadurch von der Umladeeinheit 4 auf den Piezoaktor 24 übertragen. Der Strom 5 sinkt dabei mit der Zeit, wobei der Strom 5 nach einer Zeit zum Erliegen kommen wird. Ist der Strom 5 zum Erliegen gekommen, das heißt der Strom 5 hat die Stromstärke 0 Ampere, können der zweite Schalter S2 und/oder der dritte Schalter S3 geöffnet werden, um zu verhindern, dass die elektrische Energie vom Piezoaktor 24 zurück zur Umladeeinheit 4 fließt. Durch das Laden des Piezoaktors 24 hat sich die Spannung des Piezoaktors 24 erhöht. Gemäß der gestiegenen Spannung hat sich der Piezoaktor 24 ausgelenkt. Dadurch können die Schallwellen erzeugt werden.

Durch das in Figur 1 und 2 gezeigte Verfahren kann der Piezoaktor 24 geladen werden, um dessen Auslenkung zu steuern.

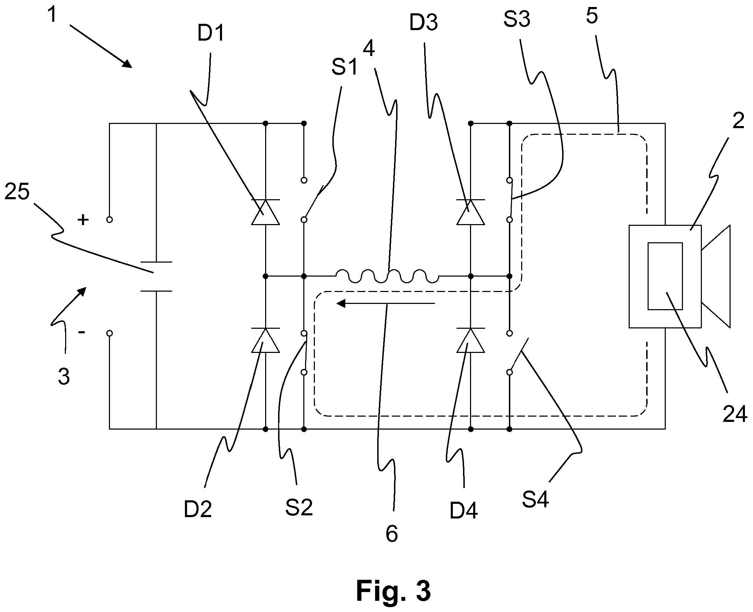

Figur 3 zeigt eine Schaltung 1 mit einer Schalterstellung zum Entladen des Piezoaktors 24 des piezoelektrischen Lautsprechers 2. Dabei sind der zweite Schalter S2 und der dritte Schalter S3 geschlossen. Der erste Schalter S1 und der vierte Schalter S4 sind geöffnet. Zu Beginn des Entladens kann der Strom 5 durch die Umladeeinheit 4 Null sein. Mit der Zeit steigt der Strom 5 durch die elektrische Spannung des Piezoaktors 24 an. Die Stromrichtung 6 ist gemäß dem vorliegenden Ausführungsbeispiel der Stromrichtung beim Laden entgegengesetzt. Nach einer Zeit, insbesondere einer Entladezeit, hat der Strom 5 durch die Umladeeinheit 4 einen, insbesondere vorbestimmten, Wert erreicht. Dann können der zweite Schalter S2 und/oder der dritte Schalter S3 geöffnet werden, so dass kein Strom 5 von dem Piezoaktor 24 zur Umladeeinheit 4 fließen kann.

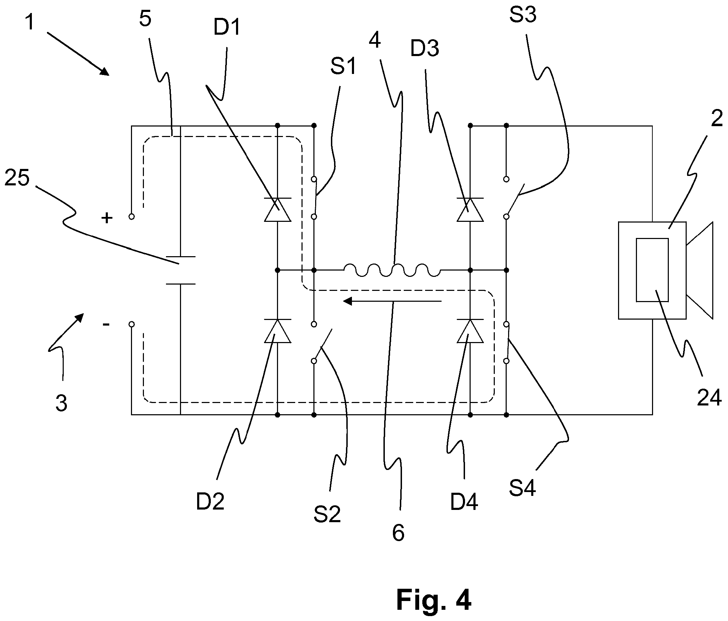

Figur 4 zeigt eine Schaltung 1 in einer Schalterstellung zum Entladen des Piezoaktors 24. In dem hier gezeigten Ausführungsbeispiel kann die in der Umladeeinheit 4 gespeicherte Energie zurück in die Energieeinheit 3 geladen werden. Diese Energie steht dann wieder zur Verfügung und dadurch kann ein Energieverbrauch für das Betreiben des piezoelektrischen Lautsprechers 2 minimiert werden.

Gemäß dem vorliegenden Ausführungsbeispiel sind die Schalter S2 und S3 geöffnet. Der erste Schalter S1 und der vierte Schalter S4 sind geschlossen, so dass der Strom 5 in Stromrichtung 6 durch die Umladeeinheit 4 zur Energieeinheit 3 fließt.

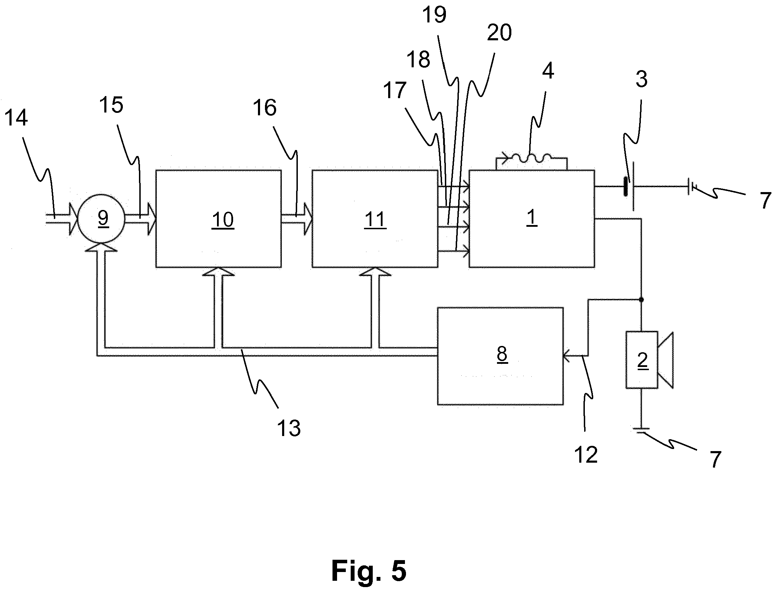

Figur 5 zeigt ein Blockdiagramm eines Verfahrens zum Betreiben des piezoelektrischen Lautsprechers 2. Das Blockdiagramm zeigt die Schaltung 1 zum Betreiben des piezoelektrischen Lautsprechers 2 und die Energieeinheit 3. Die Energieeinheit 3 und der piezoelektrische Lautsprecher 2 sind gemäß dem vorliegenden Ausführungsbeispiel mit einer Masse 7 als Bezugspotential verbunden. Der piezoelektrische Lautsprecher 2 weist ferner den hier nicht gezeigten Piezoaktor 24 (siehe Figuren 1 - 4) auf, mit dem die Auslenkung ausbildbar ist, so dass die Schallwellen erzeugt werden können. Mit Hilfe des im Blockdiagramm gezeigten Verfahrens kann der Piezoaktor 24 des piezoelektrischen Lautsprechers 2 geladen und/oder entladen werden, um dessen Auslenkung und damit die Schallerzeugung zu steuern.

Beim Verfahren wird gemäß dem vorliegenden Ausführungsbeispiel der Figur 5 eine Piezoaktorspannung 12 gemessen. Die Piezoaktorspannung 12 kann dabei an der zur Masse 7 gegenüberliegenden Seite des piezoelektrischen Lautsprechers 2 abgegriffen werden. Die Piezoaktorspannung 12 kann dabei von einer hier nicht gezeigten Messeinrichtung gemessen werden. Diese entspricht der, insbesondere aktuellen, Spannung des Piezoaktors 24. Aus der Piezoaktorspannung 12 kann die Auslenkung des Piezoaktors 24 ermittelt werden.

Im vorliegenden Ausführungsbeispiel wird die gemessene Piezoaktorspannung 12 zu einer ersten Verarbeitungseinheit 8 geleitet. Zusätzlich oder alternativ kann die erste Verarbeitungseinheit 8 auch die Messeinheit zur Erfassung der Piezoaktorspannung 12 umfassen. Die erste Verarbeitungseinheit 8 kann beispielsweise ein Digitalisierer sein. Alternativ kann die erste Verarbeitungseinheit 8 auch ein Analog-Digital-Wandler (A/D Wandler) sein. Die erste Verarbeitungseinheit 8 kann die Piezoaktorspannung 12 digitalisieren und als digitale Piezoaktorspannung 13 ausgeben. Dies hat den Vorteil, dass die digitale Piezoaktorspannung 13 auf einfache Weise weiterverarbeitet werden kann. Alternativ kann auch die Piezoaktorspannung 12 für eine Weiterverarbeitung dienen.

Ferner kann die digitale Piezoaktorspannung 13 gemäß dem vorliegenden Ausführungsbeispiel zumindest zu einem Vergleicher 9 geführt werden.

Zum Vergleicher 9 wird des Weiteren eine, insbesondere digitale, Eingabespannung 14 geführt. Die Eingabespannung 14 kann in einem hier nicht gezeigten Verfahrensschritt aus dem zur Ausgabe am piezoelektrischen Lautsprecher 2 vorgesehenen Audiosignal ermittelt werden. Das Audiosignal kann ein zeitabhängiges Pegelsignal umfassen, das in die Eingabespannung 14 umgesetzt wird. Die Eingabespannung 14 kann der Spannung entsprechen, mit der der Piezoaktor 24 aufgeladen wird, um eine Auslenkung auszubilden, die dem Audiosignal vorgesehenen Schall, beispielsweise Ton, Sprache oder Musik, entspricht. Die Eingabespannung 14 kann dabei ebenfalls zeitabhängig sein. Die Eingabespannung 14 hängt vom Audiosignal ab. Die Eingabespannung 14 wird derart ermittelt, dass die daraus resultierenden Auslenkungen des Piezoaktors 24 Schallwellen erzeugen, die dem Audiosignal entsprechen.

Die Eingabespannung 14 kann erfindungsgemäß für eine zukünftige Auslenkung ermittelt werden. Bei der Eingabespannung 14 kann es sich auch um eine zukünftige Eingabespannung 14 handeln. Zukünftig kann dabei bedeuten, dass die Eingabespannung 14 für ein zukünftiges Audiosignal ermittelt wird. Das Audiosignal bzw. ein Pegel des Audiosignals, welches/welcher durch das Verfahren für den Piezoaktor 24 bearbeitet wird, kann sich beispielsweise mit einer Arbeitsfrequenz von beispielsweise 1 MHz des Verfahrens ändern. Ein Pegel des Audiosignals kann dabei dem elektrischen Signal entsprechen, welcher zur Erzeugung des Schalls für den Piezoaktor vom Verfahren bearbeitet wird. Der Pegel des Audiosignals kann eine am Piezoaktor 24 vorgesehene Piezoaktorspannung sein, um einen entsprechenden Schall zu erzeugen. Zukünftig kann hier bedeuten, dass der Pegel des Audiosignals für eine zukünftige Periode der Arbeitsfrequenz ermittelt wird. Eine Periode entspricht dabei der Zeit zwischen zwei Abtastungen des Pegels des Audiosignals. Im Fall des 1 MHz entspricht dies etwa einer Zeit von 1 µs (1/1MHz). Das heißt, das Audiosignal, welches durch das Verfahren bearbeitet und an den Piezoaktor 24 geschickt wird, ändert alle 1 µs seinen Pegel. Die zukünftige Eingabespannung 14 kann für das nächste Abtastintervall bzw. Abtastperiode des Audiosignals ermittelt werden. Die zukünftige Eingabespannung 14 kann somit die Eingabespannung 14 sein, die in 1 µs am Piezoaktor 24 anliegen soll, um den zum Audiosignal entsprechenden Schall zu erzeugen.

Mit Hilfe des Vergleichers 9 kann ein Unterschied bzw. eine Differenz zwischen der Piezoaktorspannung 12 bzw. der digitalen Piezoaktorspannung 13 und der zukünftigen Eingabespannung 14 ermittelt werden. Beispielsweise kann der Piezoaktor 24 eine digitale Piezoaktorspannung 13 von 21 V aufweisen. Die zukünftige Eingabespannung 14, beispielsweise die Eingabespannung 14 des nächsten Abtastintervalls des Audiosignals, kann beispielsweise 21,5 V entsprechen. Die zukünftige, insbesondere gemäß dem Abtastintervall nächste, Eingabespannung 14 liegt somit höher als die gegenwärtige Piezoaktorspannung 13. Der Vergleicher 9 kann daraus eine zukünftige Differenzspannung 15 ermitteln, welche in diesem Beispiel 0,5 V beträgt. Da diese positiv ist, wird ein Laden des Piezoaktors 24 um die zukünftige Differenzspannung 15 durchgeführt. Alternativ kann die ermittelte zukünftige Differenzspannung 15 auch negativ sein. Dann ist die digitale Piezoaktorspannung 13 höher als die zukünftige Eingabespannung 14. Infolgedessen kann ein Entladen des Piezoaktors 24 durchgeführt werden.

Die zukünftige Differenzspannung 15 wird gemäß dem vorliegenden Ausführungsbeispiel zu einer zweiten Verarbeitungseinheit 10 geleitet. Die zweite Verarbeitungseinheit 10 kann beispielsweise eine Korrektureinheit umfassen, die eine Nichtlinearität des Piezoaktors 24 ausgleicht. Der Piezoaktor 24 kann die Nichtlinearität aufweisen, die darin begründet sein kann, dass sich eine Kapazität mit der Auslenkung des Piezoaktors 24 ändert. Eine Veränderung der Auslenkung des Piezoaktors 24 kann von der momentanen Auslenkung abhängen. Ist der Piezoaktor 24 beispielsweise bereits ausgelenkt, kann bei einer Erhöhung der Piezoaktorspannung 12 die weitere Auslenkung geringer ausfallen als wenn der Piezoaktor 24 geringer ausgelenkt ist. Dieses Verhalten kann mit Hilfe der zweiten Verarbeitungseinheit 10 berücksichtigt werden.

Die zweite Verarbeitungseinheit 10 kann beispielsweise eine Lade-/Entladezeit 16 ermitteln. Ist gemäß dem vorherigen Beispiel die Differenzspannung 0,5 V, wird ein Laden durchgeführt und eine Ladezeit 16 ermittelt. Die Ladezeit 16 bzw. die Lade-/Entladezeit 16 ist dabei die Zeit, währenddessen elektrische Energie von der Energieeinheit 3 auf den Piezoaktor 24 geladen wird. Die Ladezeit 16 ist beispielsweise die Zeit, während der der Schalterzustand der Figur 1 ausgebildet wird. Die Ladezeit 16 wird derart ermittelt, dass eine zukünftige Differenzenergie von der Energieeinheit 3 in die Umladeeinheit 4 geladen wird. Wird diese zukünftige Differenzenergie in einem folgenden Schritt in den Piezoaktor 24 geladen, erhöht sich die Piezoaktorspannung 12 um die Differenzspannung 15, welche in diesem Beispiel 0,5 V beträgt.

Für den Fall, dass die Differenzspannung 15 negativ ist, das heißt, dass der Piezoaktor 24 entladen werden soll, wird die Entladezeit 16 ermittelt. Für die Entladezeit 16 wird beispielsweise ein Schalterzustand gemäß der Figur 3 ausgebildet, bei dem die Differenzenergie von dem Piezoaktor 24 in die Umladeeinheit 4 geladen wird. Wird der Schalterzustand der Figur 3 für die Entladezeit 16 ausgebildet, verringert sich die Energie im Piezoaktor 24 um die Differenzenergie, was zu einer Verringerung der Piezoaktorspannung 12 um die Differenzspannung 15 führt. Die Auslenkung des Piezoaktors 24 verringert sich.

Um die Schalterzustände gemäß einem der Ausführungsbeispiele der Figuren 1 bis 4 auszubilden, kann mit Hilfe einer dritten Verarbeitungseinheit 11 für das Verfahren ein Schalterzustand zum Laden oder Entladen des Piezoaktors 24 eingestellt werden. Die dritte Verarbeitungseinheit 11 kann beispielsweise ein Pulsweitenmodulationsmodul umfassen, das ein oder mehrere Pulsweitensignale ausgeben kann, mit denen die jeweiligen Schalter S1 - S4 geschaltet werden können. Dadurch kann die Schaltung 1 mit einem Pulsweitenmodulationsverfahren betrieben werden. Die dritte Verarbeitungseinheit 11 kann vier Schaltersignale 17 - 20 an die Schaltung 1 ausgeben.

Dabei ist jedem Schaltersignal 17 - 20 ein Schalter S1 - S4 zugeordnet, so dass mit Hilfe der Schaltersignale 17 - 20 die zugehörigen Schalter S1 - S4 geschlossen und geöffnet werden können, um den Piezoaktor 24 zu Laden oder zu Entladen.

Gemäß Figur 5 kann zumindest die Piezoaktorspannung 13 auch zur zweiten und/oder dritten Verarbeitungseinheit 10, 11 geführt werden. Dies kann vorteilhaft sein, wenn die Schaltung 1 eine hier nicht gezeigte Speichereinheit aufweist, in der die digitalen Piezoaktorspannungen 13 und/oder die zukünftigen Eingabespannungen 14 gespeichert sind. In der Speichereinheit können zusätzlich oder alternativ die dazu passenden Lade-/Entladezeiten 16 und/oder die passenden Schaltersignale 17 - 20 gespeichert sein. Dadurch kann auf bereits vorhandene Werte zurückgegriffen werden. Eine erneute Berechnung der Lade-/Entladezeiten 16 und/oder der Schaltersignale 17 - 20 kann dann entfallen.

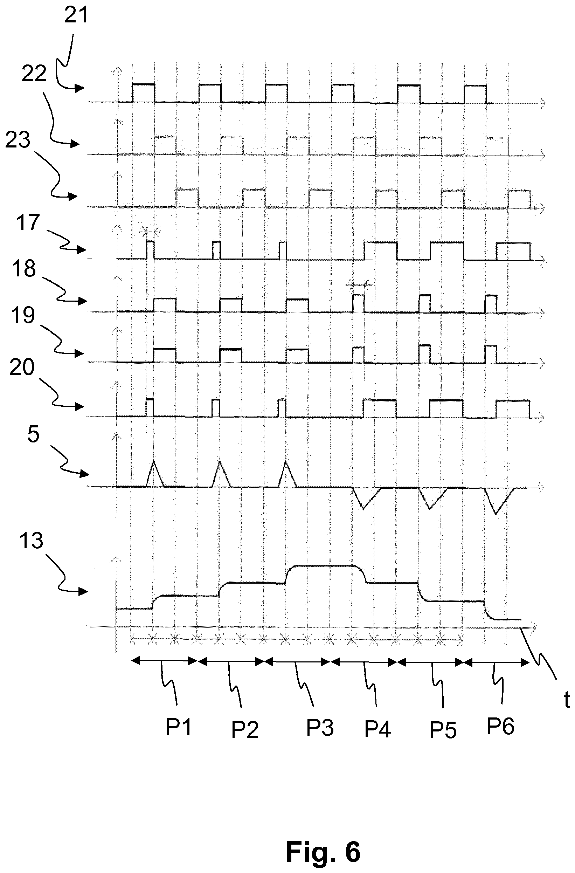

Figur 6 zeigt ein Diagramm mit zeitlichen Schaltersignalen 17 - 20, einem zeitlichen Stromverlauf 5 und einem zeitlichen Spannungsverlauf 13. Das Diagramm kann beispielsweise einen zeitlichen Ablauf von Schalterzuständen zeigen, mit denen die Schaltung 1 gemäß Figur 1 - 4 betrieben werden kann. Im obersten Bereich des Diagramms sind drei Zeitspannen 21, 22, 23 gezeigt. Ein hoher Pegel der Verläufe der drei Zeitspannen 21, 22, 23 bedeutet dabei, dass nun die jeweilige Zeitspanne vorliegt.

Darunter sind die Schaltersignale 17 - 20 der vier zugehörigen Schalter S1 - S4 gezeigt. Gemäß dem vorliegenden Ausführungsbeispiel ist das Schaltersignal 17 dem ersten Schalter S1, das zweite Schaltersignal 18 dem zweiten Schalter S2, das dritte Schaltersignal 19 dem dritten Schalter S3 und das vierte Schaltersignal 20 dem vierten Schalter S4 zugeordnet. Ein hoher Pegel bedeutet hierbei, dass der zugehörige Schalter S1 - S4 geschlossen ist, so dass ein Strom durch den entsprechenden Schalter S1 - S4 fließen kann.

Ein niedriger Pegel bedeutet, dass der zugehörige Schalter S1 - S4 geöffnet ist, so dass ein Stromkreis unterbrochen ist.

Unter den Schaltersignalen 17 - 20 ist der zeitliche Verlauf des Stroms 5 durch die Umladeeinheit 4, die gemäß Figuren 1 - 5 als Induktivität ausgebildet ist, gezeigt.

Im untersten Bereich des Diagramms ist die digitale Piezoaktorspannung 13 gezeigt. Anstelle der digitalen Piezoaktorspannung 13 könnte auch die (analoge) Piezoaktorspannung 12 gezeigt sein, da beide den gleichen Verlauf aufweisen.

Die x-Achse zeigt ferner die Zeit t an, wobei mehrere Perioden P1 - P6 der Arbeitsfrequenz der Schaltung 1 gekennzeichnet sind. Das gezeigte Diagramm zeigt lediglich einen Ausschnitt. Eine Periode P1 - P6 der Arbeitsfrequenz ist im vorliegenden Ausführungsbeispiel die Summe der drei Zeitspannen 21, 22, 23. Gemäß der Wiederholung der Periode P1 - P6 wiederholen sich auch die drei Zeitspannen 21, 22, 23. Gemäß dem vorliegenden Ausführungsbeispiel unterteilen die drei Zeitspannen 21, 22, 23 die Periode P1 - P3 in drei zeitlich gleiche Bereiche.

Gemäß dem in Figur 6 gezeigten Ausführungsbeispiel ist die erste Zeitspanne zu Beginn der Periode P1 - P6 angeordnet. Darauf folgt die zweite Zeitspanne 22 und darauf die dritte Zeitspanne 23.

Zu Beginn der Periode P1 ist der erste Zeitabschnitt 21 angeordnet. Aus einer vorangegangenen Periode P wurde gemäß dem vorliegenden Ausführungsbeispiel ermittelt, dass die zukünftige Eingabespannung 14 höher ist als die gegenwärtige digitale Piezoaktorspannung 13. Das heißt, der Piezoaktor 24 wird geladen. Für die im Diagramm erste Periode P1 werden derartige Schaltersignale 17 - 20 für die Schalter S1 - S4 ermittelt, dass die Piezoaktorspannung 13 um die Differenzspannung 15 erhöht wird. Dazu wird die Differenzenergie von der Energieeinheit 3 auf den Piezoaktor 24 geladen.

Dazu werden während des ersten Zeitabschnitts 21 der ersten Periode P1 gemäß den Schaltersignalen 17 und 20 die dazugehörigen Schalter S1 und S4 geschlossen. Die beiden Schaltersignale 18 und 19 sind auf einem niedrigen Niveau, so dass die dazugehörigen Schalter S2 und S3 geöffnet sind. In der ersten Zeitspanne 21 der ersten Periode P1 ist somit eine Schalterstellung gemäß Figur 1 ausgebildet. Die Zeit, für die in der ersten Zeitspanne 21 der ersten Periode P1 die Schalter S1 und S4 gemäß den Schaltersignalen 17 und 20 geschlossen sind, kann der Ladezeit entsprechen, in der die Differenzenergie von der Energieeinheit 3 in die Umladeeinheit 4 geladen wird. Die Ladezeit entspricht der Breite der Schaltersignale 17 und 20 in der ersten Periode P1. Die Ladezeit beginnt zu einem Zeitpunkt in der ersten Zeitspanne 21 der ersten Periode P1, so dass zum Ende der ersten Zeitspanne 21 die Differenzenergie in der Umladeeinheit 4 ist. Ferner steigt während der ersten Zeitspanne 21 der Strom 5 in der Umladeeinheit 4, insbesondere durch die Induktivität. Dadurch wird in der Umladeeinheit 4 die Differenzenergie gespeichert.

Auf die erste Zeitspanne 21 folgt die zweite Zeitspanne 22 der ersten Periode P1. Für die zweite Zeitspanne 22 ist eine weitere Schalterstellung ermittelt, die gemäß den Schaltersignalen 17 - 20 des vorliegenden Ausführungsbeispiels den geschlossenen Schaltern S2 und S3 entspricht. Die Schalter S1 und S4 sind geöffnet. Dies entspricht beispielsweise eine Schalterstellung gemäß Figur 2.

Die gemäß dem Ausführungsbeispiel in der Umladeeinheit 4 gespeicherte Energie wird über den durch die Schalter S2 und S3 ausgebildeten Stromkreis auf den Piezoaktor 24 übertragen. Dabei sinkt die Energie in der Umladeeinheit 4 gemäß dem Strom 5 zu Beginn der zweiten Zeitspanne 22. Während die Energie von der Umladeeinheit 4 auf den Piezoaktor 24 übertragen wird, steigt die digitale Piezoaktorspannung 13 gemäß dem untersten Verlauf des Diagramms. Ist die Energie von der Umladeeinheit 4 auf den Piezoaktor 24 übertragen, können die Schalter S2 und S3 geschlossen werden.

Auf die zweite Zeitspanne 22 folgt die dritte Zeitspanne 23 der ersten Periode P1. Während dieser Zeit sind in der Periode P1 alle Schalter S1 - S4 gemäß den Schaltersignalen 17 - 20 geöffnet. Während dieser Zeit kann die digitale Piezoaktorspannung 13 gemessen werden und mit der hier nicht gezeigten zukünftigen Eingabespannung 14 verglichen werden. Die zukünftige Eingabespannung 14 kann die Eingabespannung für die nächste Periode P, gemäß dem vorliegenden Ausführungsbeispiel für die zweite Periode P2, sein. Gemäß dem vorliegenden Ausführungsbeispiel ist die zukünftige Eingabespannung 14 für die zweite Periode P2 höher als die digitale Piezoaktorspannung 13 der ersten Periode P1. Daraus kann in der dritten Zeitspanne 23 die positive Differenzspannung 15 ermittelt werden, so dass ein weiteres Laden bzw. ein weiterer Ladezyklus durchgeführt wird. Ebenfalls in der dritten Zeitspanne 23 kann die Ladezeit und die Schaltersignale 17 - 20 für die Schalter S1 - S4 für die zweite Periode P2 ermittelt werden. In der zweiten Periode P2 wird der Piezoaktor 24 nochmals geladen. Gemäß dem vorliegenden Ausführungsbeispiel wird der Piezoaktor 24 außerdem in der dritten Periode P3 geladen. Die Piezoaktorspannung 13 steigt auch in der dritten Periode P3.

Des Weiteren kann in der dritten Zeitspanne 23 der dritten Periode P3 die digitale Piezoaktorspannung 13 ermittelt und mit der zukünftigen Eingabespannung 14 verglichen werden. In der dritten Periode P3 wird ermittelt, dass die digitale Piezoaktorspannung 13 im Vergleich zur zukünftigen Eingabespannung 14 zu hoch ist. Für die auf die dritte Periode P3 folgende vierte Periode P4 wird somit ein Entladen vorbereitet. Während der dritten Zeitspanne 23 der dritten Periode P3 kann die zukünftige Differenzspannung 15, welche nun negativ ist, die Differenzenergie, die vom Piezoaktor 24 in die Umladeeinheit 4 geladen wird, die Entladezeit und/oder die Schaltersignale 17 - 20 ermittelt werden.

In der ersten Zeitspanne 21 der vierten Periode P4 sind alle Schalter S1 - S4 gemäß den Schaltersignalen 17 - 20 geöffnet, so dass kein Strom fließen und somit keine Energie übertragen werden kann. Währenddessen befindet sich keine Energie in der Umladeeinheit 4. Die Umladeeinheit 4 kann dadurch Energie aufnehmen. Zu Beginn der zweiten Zeitspanne 22 der vierten Periode P4 werden die Schalter S2 und S3 geschlossen, so dass Energie vom Piezoaktor 24 in die Umladeeinheit 4 geladen wird. Die beiden Schalter S1 und S4 bleiben geöffnet. Diese Schalterstellung ist in Figur 3 gezeigt. Der Verlauf des Stroms 5 weist nun einen negativen Verlauf auf. Das heißt, der Strom 5 fließt entgegengesetzt zum Laden durch die Umladeeinheit 4. Nach der Entladezeit in der zweiten Zeitspanne 22 werden die Schalter S2 und S3 geschlossen, da in der Umladeeinheit 4 die Differenzenergie ist, die proportional zum Strom 5 durch die Umladeeinheit 4 sein kann. Danach und noch während der zweiten Zeitspanne 22 werden die Schalter S1 und S4 geschlossen, so dass die in der Umladeeinheit 4 gespeicherte Energie in die Energieeinheit 3 zurückübertragen wird. Diese Schalterstellung ist in Figur 4 gezeigt. Mit dem Übertragen der Energie von der Umladeeinheit 4 auf die Energieeinheit 3 sinkt der Strom 5 durch die Umladeeinheit 4 (es sinkt der Betrag des Stroms 5). Durch das Umladen der Energie vom Piezoaktor 24 zumindest zur Umladeeinheit 4 ist die digitale Piezoaktorspannung 13 gesunken. Das Entladen des Piezoaktors 24 wird gemäß dem vorliegenden Ausführungsbeispiel noch für die weiteren Periode P5 und P6 durchgeführt.

Die in der Figur 6 gezeigten Perioden P1 - P6 können die Perioden der Arbeitsfrequenz sein. Beträgt die Arbeitsfrequenz beispielsweise 1 MHz, weist eine Periode P1 - P6 1 µs auf. Das heißt, ein Lade- oder Entladezyklus kann innerhalb 1 µs durchgeführt werden. Die drei Zeitspannen 21, 22, 23, während denen der Piezoaktor 24 geladen oder entladen und das Laden und das Entladen für die nächste bzw. zukünftige Periode P ermittelt wird, weisen zusammen 1 µs auf. Da sich der Pegel des Audiosignals beispielsweise für eine Abtastfrequenz von 1 MHz gemäß einer Abtastperiode alle 1 µs ändert, kann die digitale Piezoaktorspannung 13 und somit die Auslenkung des Piezoaktors 24 entsprechend oft angepasst werden. Eine mögliche Abweichung der digitalen Piezoaktorspannung 13 und eine damit mögliche Abweichung der Auslenkung des Piezoaktors 24 führt zu Schallwellen mit einer entsprechend hohen Frequenz im Bereich von 1 MHz. Derartig hohe Frequenzen sind jedoch für das menschliche Gehör nicht wahrnehmbar, so dass das Regeln der digitalen Piezoaktorspannung 13 die Qualität der Musik, der Sprache oder der Töne nicht beeinflusst.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Schaltung
- 2: piezoelektrischer Lautsprecher
- 3: Energieeinheit
- 4: Umladeeinheit
- 5: Strom
- 6: Stromrichtung
- 7: Masse
- 8: erste Verarbeitungseinheit
- 9: Vergleicher
- 10: zweite Verarbeitungseinheit
- 11: dritte Verarbeitungseinheit
- 12: Piezoaktorspannung
- 13: digitale Piezoaktorspannung
- 14: Eingabespannung
- 15: Differenzspannung
- 16: Lade-/Entladezeit
- 17: erstes Schaltersignal
- 18: zweites Schaltersignal
- 19: drittes Schaltersignal
- 20: viertes Schaltersignal
- 21: erste Zeitspanne
- 22: zweite Zeitspanne
- 23: dritte Zeitspanne
- 24: Piezoaktor
- 25: Kondensator

- D1: erste Diode
- D2: zweite Diode
- D3: dritte Diode
- D4: vierte Diode
- S1: erster Schalter
- S2: zweiter Schalter
- S3: dritter Schalter
- S4: vierter Schalter
- t: Zeit
- P1 - P6: Periode der Arbeitsfrequenz

## Patentansprüche

1. Verfahren zum Betreiben eines piezoelektrischen Lautsprechers (2) zum Erzeugen von Schallwellen im hörbaren Wellenlängenspektrum und/oder im Ultraschallbereich, die einem Audiosignal entsprechen, bei dem eine gegenwärtige elektrische Piezoaktorspannung (12, 13) ermittelt wird, die zu einem gegenwärtigen Abtastintervall an einem Piezoaktor (24) anliegt,
bei dem eine zukünftige Eingabespannung (14) für den Piezoaktor (24), die am nächsten Abtastintervall am Piezoaktor (24) anliegen soll, mit der gegenwärtigen elektrischen Piezoaktorspannung (12, 13) verglichen und
daraus eine zukünftige Differenzspannung (15) ermittelt wird,
bei dem in Abhängigkeit der zukünftigen Differenzspannung (15) eine Lade- oder eine Entladezeit ermittelt wird und
bei dem der Piezoaktor (24) des piezoelektrischen Lautsprechers (2) mit elektrischer Energie einer Energieeinheit (3) unter Verwendung der Lade- oder Entladezeit geladen oder entladen wird, so dass sich die Piezoaktorspannung (12) um die zukünftige Differenzspannung erhöht oder verringert, wodurch Auslenkungen des Piezoaktors resultieren und die Schallwellen erzeugt werden, die dem Audiosignal entsprechen.

2. Verfahren nach dem vorherigen Anspruch, bei dem aus einem zur Ausgabe am piezoelektrischen Lautsprecher (2) vorgesehenen Audiosignal die zukünftige Eingabespannung (14) des Piezoaktors (24) ermittelt wird.

3. Verfahren nach einem der vorherigen Ansprüche, bei dem beim Laden die elektrische Energie von der Energieeinheit (3) auf eine Umladeeinheit (4) und von der Umladeeinheit (4) in den Piezoaktor (24) geladen wird und/oder beim Entladen des Piezoaktors (24) die elektrische Energie vom Piezoaktor (24) auf die Umladeeinheit (4) geladen und von der Umladeeinheit (4) in die Energieeinheit (3) geladen wird.

4. Verfahren nach einem oder mehreren der vorherigen Ansprüche, bei dem zumindest aus der zukünftigen Differenzspannung (15) und/oder der gemessenen Piezoaktorspannung (12, 13) eine zukünftige elektrische Differenzenergie ermittelt wird.

5. Verfahren nach einem oder mehreren der vorherigen Ansprüche, bei dem in Abhängigkeit der zukünftigen Eingabespannung (14), der zukünftigen Differenzenergie, der zukünftigen Differenzspannung (15) und/oder der gemessenen Piezoaktorspannung (12, 13) eine zukünftige Ladezeit, während der die elektrische Energie von der Energieeinheit (3) in die Umladeeinheit (4), und/oder eine zukünftige Entladezeit ermittelt wird, während der die elektrische Energie von dem Piezoaktor (24) in die Umladeeinheit (4) geladen wird.

6. Verfahren nach dem vorherigen Anspruch, bei dem die Ladezeit und/oder die Entladezeit in einer Speichereinheit gespeichert sind und die gespeicherte Ladezeit und/oder Entladezeit in Abhängigkeit der zukünftigen Eingabespannung (14), der gegenwärtigen Piezoaktorspannung (12, 13), der zukünftigen Differenzspannung (15) und/oder der zukünftigen Differenzenergie ermittelt und/oder ausgewählt wird.

7. Verfahren nach einem oder mehreren der vorherigen Ansprüche, bei dem das Laden und/oder das Entladen des Piezoaktors (24) mit Hilfe eines Pulsweitenmodulationsverfahrens durchgeführt wird.

8. Verfahren nach einem oder mehreren der vorherigen Ansprüche, bei dem das Laden, das Entladen und/oder das Ermitteln der Differenzspannung (15), der Differenzenergie, der Ladezeit, der Entladezeit und/oder das Ermitteln der Piezoaktorspannung (12, 13) schrittweise und/oder periodisch mit einer Arbeitsfrequenz durchgeführt wird.

9. Verfahren nach dem vorherigen Anspruch, bei dem eine Periode (P1 - P6) der Arbeitsfrequenz in eine erste Zeitspanne (21), in eine, insbesondere zeitlich darauffolgende, zweite Zeitspanne (22) und in eine, insbesondere zeitlich darauffolgende, dritte Zeitspanne (23) unterteilt ist.

10. Verfahren nach dem vorherigen Anspruch, bei dem in der ersten Zeitspanne (21) die elektrische Energie von der Energieeinheit (3) auf die Umladeeinheit (4) geladen wird, wobei das Laden der Umladeeinheit (4) von der Energieeinheit (3) zu einem Zeitpunkt erfolgt, so dass zum Ende der ersten Zeitspanne (21) in der Umladeeinheit (4) die Differenzenergie gespeichert ist.

11. Verfahren nach dem Anspruch 9, bei dem das Laden oder das Entladen des Piezoaktors (24) zu Beginn der zweiten Zeitspanne (22) beginnt.

12. Verfahren nach dem Anspruch 9, bei dem in der dritten Zeitspanne (23) die Piezoaktorspannung (12, 13) gemessen, die Differenzspannung (15), die Eingabespannung (14), die Differenzenergie ermittelt und/oder der Piezoaktor (24) entladen wird.

13. Schaltung (1) zum Betreiben eines piezoelektrischen Lautsprechers (2) zum Erzeugen von Schallwellen im hörbaren Wellenlängenspektrum und/oder im Ultraschallbereich, wobei mit Hilfe der Schaltung (1) ein Piezoaktor (24) des piezoelektrischen Lautsprechers (2) geladen und/oder entladen werden kann, so dass Auslenkungen des Piezoaktors (24) ausbildbar sind, so dass die Schallwellen erzeugbar sind, wobei mit Hilfe der Schaltung (1) elektrische Energie zwischen einer Energieeinheit (3) und dem Piezoaktor (24) umladbar ist,
**dadurch gekennzeichnet,**
**dass** die Schaltung (1) ausgebildet ist, ein Verfahren gemäß einem der vorherigen Ansprüche auszuführen.

## Claims

1. A method for operating a piezoelectric speaker (2) for generating sound waves in the audible wavelength spectrum and/or in the ultrasonic range,
corresponding to an audio signal, in which a present electrical piezo actuator voltage (12, 13) is determined, being applied to a piezo actuator (24) at a present sampling interval, in which a future input voltage (14) for the piezo actuator (24), to be applied to the piezo actuator (24) at the following sampling interval is compared with the present electrical piezo actuator voltage (12, 13) and
a future differential voltage (15) being determined therefrom, in which a charging or discharging time is determined depending on the future differential voltage (15) and
in which the piezo actuator (24) of the piezoelectric speaker (2) is charged or discharged with electrical energy of an energy unit (3) using the charging or discharging time so that the piezo actuator voltage (12) increases or decreases by the future differential voltage, resulting in deflections of the piezo actuator and generating the sound waves corresponding to the audio signal.

2. The method according to the preceding claim, in which the future input voltage (14) of the piezo actuator (24) is derived from an audio signal intended for outputting at the piezoelectric speaker (2).

3. The method according to any one of the preceding claims, in which when charging, the electrical energy from the energy unit (3) is charged to a transfer charging unit (4) and from the transfer charging unit (4) to the piezo actuator (24), and/or
that when discharging the piezo actuator (24), the electrical energy is charged from the piezo actuator (24) to the transfer charging unit (4) and from the transfer charging unit (4) to the energy unit (3).

4. The method according to any one or more of the preceding claims, in which a future differential electrical energy is derived from at least the future differential voltage (15) and/or the measured piezo actuator voltage (12, 13).

5. The method according to any one or more of the preceding claims, in which depending on the future differential energy, the future differential voltage (15), and/or the measured piezo actuator voltage (12, 13), a future charging time during which the electrical energy is charged from the energy unit (3) into the transfer charging unit (4) is derived, and/or a future discharging time during which the electrical energy is charged from the piezo actuator (24) to the transfer charging unit (4) is derived.

6. The method according to the preceding claim, in which the charging time and/or the discharging time are stored in a memory unit and the stored charging time and/or discharging time is determined and/or selected depending on the future input voltage (14), the present piezo actuator voltage (12, 13), the future differential voltage (15) and/or the future differential energy.

7. The method according to any one or more of the preceding claims, in which the charging and/or the discharging of the piezo actuator (24) is performed by means of a pulse-width-modulation method.

8. The method according to any one or more of the preceding claims, in which the charging, the discharging, and/or the determining of the differential voltage (15), the differential energy, the charging time, the discharging time, and/or the determining of the piezo actuator voltage (12, 13) is performed incrementally and/or periodically at a working frequency.

9. The method according to the preceding claim, in which a period (P1 - P6) of the working frequency is divided into a first span of time (21), into a second span of time (22) particularly subsequent thereto, and into a third span of time (23) particularly subsequent thereto.

10. The method according to the preceding claim, in which the electrical energy is charged from the energy unit (3) to the transfer charging unit (4) in the first span of time (21), wherein the charging of the transfer charging unit (4) from the energy unit (3) takes place at a point in time such that the differential energy is stored in the transfer charging unit (4) at the end of the first span of time (21).

11. The method according to claim 9, in which the charging or discharging of the piezo actuator (24) begins at the beginning of the second span of time (22).

12. The method according to claim 9, in which the piezo actuator voltage (12, 13) is measured, the differential voltage (15), the input voltage (14), the difference energy is derived, and/or the piezo actuator (24) is discharged in the third span of time (23).

13. A circuit (1) for operating a piezoelectric speaker (2) for generating sound waves in the audible wavelength spectrum and/or in the ultrasonic range, a piezo actuator (24) of the piezoelectric speaker (2) being able to be charged and/or discharged by means of the circuit (1), such that deflections of the piezo actuator (24) can be shaped such that the sound waves can be generated,
electrical energy being able to be charged between an energy unit (3) and the piezo actuator (24) by means of the circuit (1),
**characterized in that**,
the circuit (1) is implemented for performing a method according to one of the preceding claims.

## Revendications

1. Procédé pour faire fonctionner un haut-parleur piézoélectrique (2) pour générer des ondes acoustiques dans le spectre de longueurs d'onde audible et/ou dans la plage ultrasonique, qui correspondent à un signal audio,
dans lequel est déterminée une tension électrique actuelle (12, 13) d'un actionneur piézoélectrique, qui est appliquée à un actionneur piézoélectrique (24) à un intervalle d'échantillonnage actuel,
dans lequel une tension d'entrée future (14) pour l'actionneur piézoélectrique (24), qui doit être appliquée à l'actionneur piézoélectrique (24) au prochain intervalle d'échantillonnage, est comparée à la tension électrique actuelle (12, 13) de l'actionneur piézoélectrique et
une tension différentielle (15) future est déterminée à partir de cette comparaison,
dans lequel une durée de charge ou une durée de décharge est déterminée en fonction de la future tension différentielle (15) et
dans lequel l'actionneur piézoélectrique (24) du haut-parleur piézoélectrique (2) est chargé ou déchargé avec l'énergie électrique d'une unité d'énergie (3) par utilisation de la durée de charge ou de décharge, de sorte que la tension de l'actionneur piézoélectrique (12) augmente ou diminue de la future tension différentielle, ce qui entraîne des déviations de l'actionneur piézoélectrique et génère les ondes acoustiques qui correspondent au signal audio.

2. Procédé selon la revendication précédente, dans lequel la future tension d'entrée (14) de l'actionneur piézoélectrique (24) est déterminée à partir d'un signal audio prévu pour la sortie au haut-parleur piézoélectrique (2).

3. Procédé selon l'une quelconque des revendications précédentes, dans lequel, pendant la charge, l'énergie électrique est chargée de l'unité d'énergie (3) à une unité de transfert (4) et de l'unité de transfert (4) à l'actionneur piézoélectrique (24) et/ou
pendant la décharge de l'actionneur piézoélectrique (24), l'énergie électrique est chargée de l'actionneur piézoélectrique (24) vers l'unité de transfert (4) et chargée de l'unité de transfert (4) vers l'unité d'énergie (3).

4. Procédé selon l'une quelconque ou plusieurs des revendications précédentes, dans lequel une énergie électrique différentielle future est déterminée au moins à partir de la tension différentielle future (15) et/ou de la tension mesurée (12, 13) de l'actionneur piézoélectrique.

5. Procédé selon l'une quelconque ou plusieurs des revendications précédentes, dans lequel, en fonction de la future tension d'entrée (14), de la future énergie différentielle, de la future tension différentielle (15) et/ou de la tension mesurée (12, 13) de l'actionneur piézoélectrique, il est déterminé une durée de charge future, pendant laquelle l'énergie électrique est chargée de l'unité d'énergie (3) dans l'unité de transfert (4), et/ou une durée de décharge future, pendant laquelle l'énergie électrique est chargée de l'actionneur piézoélectrique (24) dans l'unité de transfert (4).

6. Procédé selon la revendication précédente, dans lequel la durée de charge et/ou la durée de décharge est/sont stockée(s) dans une unité de mémoire et la durée de charge et/ou la durée de décharge stockée(s) est/sont déterminée(s) et/ou sélectionnée(s) en fonction de la future tension d'entrée (14), de la tension actuelle (12, 13) de l'actionneur piézoélectrique, de la future tension différentielle (15) et/ou de la future énergie différentielle.

7. Procédé selon l'une quelconque ou plusieurs des revendications précédentes, dans lequel la charge et/ou la décharge de l'actionneur piézoélectrique (24) est/sont effectuée(s) au moyen d'un procédé de modulation d'impulsions en durée.

8. Procédé selon l'une quelconque ou plusieurs des revendications précédentes, dans lequel la charge, la décharge et/ou la détermination de la tension différentielle (15), de l'énergie différentielle, de la durée de charge, de la durée de décharge et/ou la détermination de la tension (12, 13) de l'actionneur piézoélectrique est/sont effectuée(s) par étapes et/ou périodiquement avec une fréquence de fonctionnement.

9. Procédé selon la revendication précédente, dans lequel une période (P1 - P6) de la fréquence de fonctionnement est divisée en une première période de temps (21), en une seconde période de temps (22), en particulier succédant à la première période de temps, et en une troisième période de temps (23), en particulier succédant à la seconde période de temps.

10. Procédé selon la revendication précédente, dans lequel, dans la première période de temps (21), l'énergie électrique est chargée de l'unité d'énergie (3) à l'unité de transfert (4), dans lequel la charge de l'unité de transfert (4) à partir de l'unité d'énergie (3) a lieu à un instant tel qu'à la fin de la première période de temps (21), l'énergie différentielle est stockée dans l'unité de transfert (4).

11. Procédé selon la revendication 9, dans lequel la charge ou la décharge de l'actionneur piézoélectrique (24) commence au début de la seconde période de temps (22).

12. Procédé selon la revendication 9, dans lequel, dans la troisième période de temps (23), la tension (12, 13) de l'actionneur piézoélectrique est mesurée, la tension différentielle (15), la tension d'entrée (14), l'énergie différentielle sont déterminées et/ou l'actionneur piézoélectrique (24) est déchargé.

13. Circuit (1) pour faire fonctionner un haut-parleur piézoélectrique (2) pour générer des ondes acoustiques dans le spectre de longueurs d'onde audible et/ou dans la plage ultrasonique, dans lequel un actionneur piézoélectrique (24) du haut-parleur piézoélectrique (2) peut être chargé et/ou déchargé à l'aide du circuit (1), de sorte que des déviations de l'actionneur piézoélectrique (24) peuvent être formées, de sorte que les ondes acoustiques peuvent être générées,
dans lequel de l'énergie électrique peut être transférée entre une unité d'énergie (3) et l'actionneur piézoélectrique (24) au moyen du circuit (1),
**caractérisé en ce que**
le circuit (1) se présente sous une forme pour exécuter un procédé selon l'une quelconque des revendications précédentes.
